# EUROPÄISCHE PATENTANMELDUNG

(11) **EP 2 395 572 A1**
(43) Veröffentlichungstag der Anmeldung: **14.12.2011**
(21) Anmeldenummer: 10165581.9
(22) Anmeldetag: 10.06.2010
(51) Int. Cl.: H01L 51/50, H01L 51/00

(54) **Schichtaufbau umfassend elektrotechnische Bauelemente**

(71) Anmelder: Bayer MaterialScience AG, 51368 Leverkusen (DE)
(72) Erfinder: Kunz, Rainer, Dr., 56379 Holzappel (DE); Hedderich, Wilfried, 40724 Hilden (DE); Benecke, Carsten, 79576 Weil am Rhein (DE)

(57) **Zusammenfassung**

Gegenstand der vorliegenden Erfindung ist ein Schichtaufbau umfassend ein Substrat (1), mindestens eine LEC (7) (light emitting electrochemical cell) und mindestens ein weiteres elektrotechnisches Bauelement (4, 5, 8), ein Verfahren zur Herstellung dieses Schichtaufbaus und dessen Verwendung zur Ausbildung von kleinen und großen Anzeige- und Steuerelementen und zur Ausbildung von Gehäuse-elementen für mobile oder stationäre Elektronikgeräte oder kleiner oder großer Haushaltsgeräte oder zur Ausbildung von Tastatursystemen ohne bewegliche Bauteile.

## Beschreibung

Gegenstand der vorliegenden Erfindung ist ein Schichtaufbau umfassend ein Substrat, mindestens eine LEC (light emitting electrochemical cell) und mindestens ein weiteres elektrotechnisches Bauelement, ein Verfahren zur Herstellung dieses Schichtaufbaus und dessen Verwendung zur Ausbildung von kleinen und großen Anzeige- und Steuerelementen und zur Ausbildung von Gehäuseelementen für mobile oder stationäre Elektronikgeräte oder kleiner oder großer Haushaltsgeräte oder zur Ausbildung von Tastatursystemen ohne bewegliche Bauteile.

In vielen Bereichen der Technik besteht der Bedarf, ein elektrisches oder elektronisches Gerät mit der Komponente "Licht", also einer Beleuchtung bzw. einer Anzeige, zu versehen. Dies kann beispielsweise die Hintergrundbeleuchtung eines Schalters sein, die den Ort und/oder den An-/AusZustand des Schalters anzeigt, oder es kann die Anzeige eines Mobilfunkgerätes sein, die aufleuchtet, wenn die Antenne des Mobilfunkgerätes ein Signal empfängt. Auch andere elektrotechnische Bauelemente außer Schaltern oder Antennen sollen mit einer Beleuchtung versehen werden können. Die Komponente "Licht" soll vorzugsweise mit einer elektrisch betriebenen Lampe bzw. Anzeige zur Verfügung gestellt werden.

Darüber hinaus besteht der Bedarf, ein solches elektrisches oder elektronisches Gerät ortsunabhängig und auch bei Dunkelheit betreiben zu können. Dies bedingt, dass es eine Batterie oder einen Akkumulator enthalten muss, jedoch soll es auch an eine übergeordnete Stromversorgung anschließbar sein, beispielsweise die Batterie des Gerätes, das den Schichtaufbau umfasst, beispielsweise eine eigenständige Bedienkonsole eines Automobils, die Batterie des Erzeugnisses, beispielsweise eines Automobils, in das das Gerät eingebaut ist, die öffentliche Stromversorgung, wenn der Schichtaufbau beispielsweise in ein Haushaltsgerät eingebaut ist.

Dabei soll das Gerät möglichst leicht und flach sein. Dies bedingt, dass auch der Schichtaufbau, mit dem das Gerät ausgerüstet wird, möglichst leicht und flach sein muss. Daher soll der Schichtaufbau auch die gegebenenfalls nötige Batterie umfassen, die die Stromversorgung aller elektrotechnischen Bauelemente des Schichtaufbaus sicherstellt. Um den Zusammenbau des Gerätes zu erleichtern, soll der Schichtaufbau nur ein Substrat umfassen und nur ein Bauteil bilden. Damit der Schichtaufbau beim Zusammenbau des elektrischen oder elektrotechnischen Gerätes stabil bleibt, soll der Schichtaufbau hinterspritzt werden können.

Um möglichst wenig fehleranfällig und um an der Oberfläche leicht zu reinigen zu sein, soll der Schichtaufbau ohne bewegliche Bauteile auskommen und eine durchgehende Oberfläche ohne Unterbrechungen bilden.

Um für den Benutzer ansprechend zu wirken und die Bedienung des Gerätes zu erleichtern, soll das Gerät dreidimensional verformte Bereiche aufweisen.

Damit das elektrische oder elektrotechnische Gerät einem Kunden möglichst kostengünstig angeboten werden kann, soll der Schichtaufbau möglichst einfach und preiswert herstellbar sein. Daher soll der Schichtaufbau zumindest teilweise mittels eines Druckverfahrens oder durch Spray Coating herstellbar sein. Auch soll aus diesem Grund auf elektrotechnische Bauelemente verzichtet werden können, die aufwändige Barriereschichten gegen Sauerstoff und Feuchtigkeit zur einwandfreien Funktion benötigen.

Grundsätzlich sind solche Vorrichtungen aus dem Stand der Technik bekannt. So weisen Schalter häufig eine Hintergrundbeleuchtung auf, die es ermöglicht, den Schalter beispielsweise an einer Vorrichtung, wie beispielsweise an einem Haushaltsgerät oder einem Lichtschalter in einem Hausflur, auch bei Dunkelheit oder bei unzureichenden Beleuchtungsbedingungen betätigen zu können. Darüber hinaus können entsprechende Beleuchtungen auch den Status des Schalters, wie den Zustand "An" oder "Aus", anzeigen. Im Allgemeinen wird dazu eine Licht emittierende Diode (LED = light emitting diode) oder aber eine kleine konventionelle Lampe als Lichtquelle für die Hintergrundbeleuchtung von Schalter verwendet, wobei in einigen Fällen das Licht über zusätzliche Streufolien oder sogenannten light-pipes oder light-guides verteilt wird. Die Kombination aus Schalter und Hintergrundbeleuchtung wird üblicherweise aus mindestens zwei getrennten Einheiten aufgebaut, wie beispielsweise aus einem mechanischen Schalter und entsprechenden LEDs; einem mechanischen Schalter und ACPEL-Folien (ACPEL = alternating current powder electroluminescence) oder gedruckten Schaltern und LEDs. Diese aus dem Stand der Technik bekannten Kombinationen von beleuchteten Schaltern aus getrennten Elementen weisen den Nachteil auf, dass ihre Bereitstellung teuer ist und sie aufgrund der Verwendung von mechanischen Bauteilen für den Schalter störungs- und wartungsempfindlich sind. Darüber hinaus treten weitere Nachteile auf, wie höheres Gewicht, eingeschränkte Form- und damit eingeschränkte Designfreiheit und eine höhere Einbautiefe.

So offenbart US2009/108985A1 einen gedruckten kapazitiven Schalter, der von LEDs hinterleuchtet ist. Jedoch werden die LEDs nicht gedruckt. US2005/0206623A1 offenbart einen kapazitiven Schalter, der von einer ACPEL-Folie hinterleuchtet ist. US2008/202912A1 offenbart einen von LEDs oder OLEDs (OLED = organic light emitting diode) hinterleuchteten kapazitiven Schalter. US2007/031161A1 offenbart einen gedruckten kapazitiven Schalter auf einer verformten und hinterspritzten Kunststofffolie. Allerdings offenbart dieses Dokument nicht, dass dieser Schalter hinterleuchtet ist. Dass ACPEL-Folien gedruckt und hinterspritzt werden können, ist jedoch beispielsweise aus WO98/49871A1 bekannt.

ACPEL-Folien weisen den Nachteil auf, dass sie eine elektrische Versorgung benötigen, die aus einer hohen Wechselspannung (typischerweise 110V) bei einer hohen Frequenz (typischerweise 400Hz) besteht. Dafür muss ein spezieller elektronischer Treiber zur Verfügung gestellt werden, der zusätzlich Kosten erzeugt. Ein weiterer Nachteil der Kombination von ACPEL-Folien mit beispielsweise kapazitiven Schaltern ist, dass die erforderlichen elektrische Versorgung bzw. die Ansteuersignale a) für die ACPEL-Folie und b) für den kapazitiven Schalter wechselwirken. Hierfür ist einerseits eine elektromagnetische Abschirmung zwischen den Schichten nötig, damit es hier nicht zu ungewollten Interferenzen und damit einhergehenden Fehlfunktionen kommt, und andererseits muss ein Mehraufwand bei der Ausleseelektronik der kapazitiven Schalter betrieben werden, da sich trotz elektrischer Abschirmung die Interferenzen nicht vollständig eliminieren lassen und somit die Ausleseelektronik stärker verrauschte Signale (schlechtes Signal-zu-Rausch-Verhältnis) verarbeiten muss. Hier ist ferner insbesondere zusätzlich eine Dunkel- (ACPEL-Folie eingeschaltet) und Tag (ACPEL-Folie ausgeschaltet) Logik zu erstellen, mit der die Schaltsignale sicher identifiziert werden können, da sich das Signal-zu-Rausch-Verhältnis der auszuwertenden Signale der kapazitiven Schalter bei eingeschalteter bzw. ausgeschalteter ACPEL-Folie stark unterscheiden. Die vergleichsweise hohe Spannung, die zum Betrieb der ACPEL-Folie nötig ist, kann bei Fehlern zur Gefährdung des Bedieners führen.

Das Problem dieser unerwünschten Wechselwirkung stellt sich in ähnlicher Weise, wenn ACPEL-Folien mit anderen Schaltertypen, beispielsweise resistiven Schaltern, oder anderen elektrotechnischen Bauelementen, die gegenüber elektromagnetischen Feldern oder Wellen empfindlich sind, beispielsweise Antennen oder Sensoren, kombiniert werden.

LEDs weisen den Nachteil dieser elektromagnetischen Wechselwirkung mit anderen elektrotechnischen Bauelementen nicht auf, jedoch sind sie auch in Kombination mit optischen Diffusorfolien nicht in der Lage, andere Bauelemente, die dreidimensional verformt sind, gleichmäßig und schattenfrei zu hinterleuchten, denn LEDs können nicht dreidimensional verformt werden. Auch erhöhen LEDs die Bautiefe einer Anordnung, wenn sie sich bei Hinterleuchtung eines elektrotechnischen Bauelements unter diesem befinden oder sie benötigen zusätzlich aufwändige Strukturen wie Streufolien oder sogenannte light-pipes oder light-guides. OLEDs und PLEDs (PLED = polymeric light emitting diode) weisen den letztgenannten Nachteil von LEDs nicht auf, jedoch sind OLEDs und PLEDs extrem empfindlich gegen Sauerstoff und Feuchtigkeit. Dies bedingt, dass sie äußerst aufwendig mit Barrierefolien sehr hoher Qualität bzw. -schichten vor Sauerstoff und Feuchtigkeit geschützt werden müssen.

Diese Barrierefolien- bzw. schichten weisen typischerweise eine Wasserdampfdurchlässigkeit von 10⁻⁶ g/m⁻²•Tag, und eine Sauerstoffdurchlässigkeit von 10⁻⁵ cm³/m⁻²•Tag auf.

Aufgabe der Erfindung ist es daher, einen Schichtaufbau auf einem einzigen Substrat zur Verfügung zu stellen, der eine mit elektrischer Energie betriebene Lampe in Kombination mit mindestens einem weiteren elektrotechnischen Bauelement aufweist.

Die Lampe des Schichtaufbaus soll mit dem mindestens einen weiteren elektrotechnisches Bauelement nicht elektromagnetisch wechselwirken. Auch soll diese Lampe mit einer geringen elektrischen Gleichspannung betrieben werden können.

Der Schichtaufbau soll weiters: eine geringe Dicke aufweisen, ohne bewegliche Bauteile auskommen und eine durchgehende Oberfläche ohne Unterbrechungen bilden, möglichst leicht sein, dreidimensional verformte Bereiche aufweisen, und hinterspritzbar sein.

Der Schichtaufbau soll einfach und preiswert herstellbar sein. Daher soll auf elektrotechnische Bauelemente verzichtet werden können, die sehr aufwändige Barriereschichten gegen Sauerstoff und Feuchtigkeit zur einwandfreien Funktion benötigen. Insbesondere soll der Schichtaufbau zumindest teilweise mittels eines Druckverfahrens oder durch Spray Coating herstellbar sein.

Gelöst wird die Aufgabe durch einen Schichtaufbau mit den Merkmalen des Hauptanspruchs, und zwar durch einen:
Schichtaufbau umfassend
   A) ein Substrat,
   B) mindestens eine LEC (light emitting electrochemical cell) und
   C) mindestens ein weiteres elektrotechnisches Bauelement ausgewählt aus der Gruppe bestehend aus Antenne, Schalter, Sensor, Batterie, Photovoltaikzelle, Aktuator, Energiekonverter oder Kombinationen von zwei oder mehreren gleichen oder verschiedenen dieser Bauelemente,
dadurch gekennzeichnet, dass sich die mindestens eine LEC und das mindestens eine weitere elektrotechnische Bauelement auf demselben Substrat befinden und der Schichtaufbau mindestens einen dreidimensional verformten Bereich aufweist und/oder als Ganzes dreidimensional verformt ist.

Vorzugsweise Ausführungsformen finden sich in den Unteransprüchen.

Das Substrat besteht im Wesentlichen oder ganz aus einem Polymer, ausgewählt aus der Gruppe bestehend aus Polycarbonaten (PC), Polyestern, bevorzugt Polyethylenterephthalaten (PET), Polyethylennaphthalat (PEN), Polymethylmethacrylat (PMMA), Polyamiden, Polyimiden, Polyarylaten, organischen thermoplastischen Celluloseestern und Polyfluorkohlenwasserstoffen oder Mischungen aus diesen Polymeren, bevorzugt ausgewählt aus Polycarbonaten, Polyethylenterephthalaten, Polyethylennaphthalat und Polyimiden, besonders bevorzugt ausgewählt aus Polycarbonaten, Polyethylenterephthalaten und Polyethylennaphthalat. Vorzugsweise ist das Substrat eine Folie aus einem der vorgenannten Materialien. Unter Folie im Sinne der vorliegenden Erfindung wird ein im Wesentlichen zweidimensionaler Körper mit einer Dicke von 10 µm bis 1000 µm, bevorzugt von 50 µm bis 750 µm, besonders bevorzugt von 125 µm bis 500 µm verstanden. Im Sinne der Erfindung wird unter einem im Wesentlichen zweidimensionalen Körper verstanden, dass die Längen der Großflächen mindestens zehnmal größer sind als die Dicke des Körpers, wobei diese Längen gleich oder unterschiedlich sein können.

Polycarbonate sind beispielsweise solche auf der Grundlage von Bisphenol A, insbesondere Folien mit der Bezeichnung Bayfol ® CR (Polycarbonat/Polybutylenterephthalat-Folie) Makrofol ® TP oder Makrofol ® DE der Bayer Material Science AG.

Polyethylenterephthalate sind beispielsweise Polyalkylenterephtalate, insbesondere Polybutylenterephthalat.

PEN ist insbesondere solches, das unter den Bezeichnungen Kaladex ® und Teonex ® von der DuPont Teijin Films Luxembourg S.A. vertrieben wird.

Unter einer LEC im Sinne der vorliegenden Erfindung wird ein elektrotechnisches Bauelement verstanden, das als wesentliche Funktionsteile eine Anode, ein lichtemittierendes Polymer, welches als Additive ein oder mehrere Elektrolyte, ein oder mehrere Salze oder weitere Zusätze, beispielsweise Surfactants, enthalten kann, und eine Kathode umfasst. Die Zusammensetzung der lichtemittierenden Schicht kann variieren. Die Additive können im Betrieb mehrere Funktionen übernehmen, beispielsweise können sie als Ionenleiter, Anion oder Kation dienen. Ferner können die Additive funktionalisiert und mit dem lichtemittierenden Polymer chemisch vernetzt sein. Schließlich können auch sowohl metallische Partikel mit Größen im Nano- und Mikrometerbereich als auch Quantum Dots in das lichtemittierenden Polymer hinein dispergiert sein. Nachfolgend wird diese Schicht als LEP-Schicht (LEP = light emitting polymer) bezeichnet.

Die LEC kann in verschiedenen Ausführungsformen vorliegen. In einer typischen Ausführungsform, der vertikalen Anordnung, sind die Anode, die LEP-Schicht und die Kathode übereinander angeordnet. In einer alternativen Anordnung, der planaren Anordnung, können die Anode, die LEP-Schicht und die Kathode auch nebeneinander angeordnet sein; so können beispielsweise auf einer bereits gedruckten LEP-Schicht zwei sich gegenüberliegende Metallelektroden (Anode, Kathode) aufgebracht werden. Diese können parallel oder in einer anderen Form ausgeprägt sein. Da der erfindungsgemäße Schichtaufbau mindestens eine LEC umfasst und eine LEC mindestens eine LEP, umfasst der erfindungsgemäße Schichtaufbau folglich auch mindestens eine LEP.

Darüber hinaus lassen sich pixelierte Leuchtsegmente, beispielsweise eine Sieben-SegmentAnzeige, in nahezu beliebiger Weise herstellen. Auf diese Weise stellt die LEC nicht nur eine Lampe dar, sondern bildet schon an und für sich eine Anzeige.

Zusätzlich kann die LEC eine so genannte Getterschicht umfassen. Diese Getterschicht, soweit vorhanden, liegt vorzugsweise auf der dem Substrat abgewandten Seite der Kathode. Die Getterschicht hat die Aufgabe, die restliche Feuchte, die aus den einzelnen Schichten oder von Außen kommen kann, zu absorbieren. Dadurch erhöht sich die Lebensdauer des Leuchtelements. Jedoch ist eine Getterschicht nicht unbedingt nötig, insbesondere wenn die LEC keine lange Lebensdauer haben muss.

Die Vorteile einer LEC gegenüber beispielweise OLED und PLED liegen in ihrem einfachen Aufbau begründet.

Im Gegensatz zu den LECs besitzen OLEDs und PLEDs eine wesentlich größere Anzahl von Schichten, beispielsweise zusätzlich Loch- bzw. Elektroninjektionsschichten, Loch- bzw Elektronblockierschichten usw. Diese Schichten fordern darüber hinaus Schichtdicken im Bereich von wenigen 100 Nanometern, die mit einem Druckverfahren nur sehr schwer zu realisieren sind. Die Dicken der Licht emittierenden Schichten von OLEDs und PLEDs liegen sogar im Bereich von wenigen 10 nm.

Dagegen besteht die LEC im einfachsten Fall aus drei Schichten (Anode, LEP, Kathode), wobei die Dicke der LEP-Schicht im Bereich von einigen hundert Nanometern liegt, in planaren Anordnungen kann die Dicke sogar im Bereich von einigen Millimetern liegen. Weiterhin ist die Funktionsweise der LEC gegenüber Abweichungen bezüglich der Dicke der LEP unempfindlicher als es bei den OLEDs und PLEDs der Fall ist.

Daraus ergibt sich als weiterer, wesentlicher Vorteil der LEC, dass alle Schichten der LEC durch ein einfaches Druckverfahren, beispielsweise durch Siebdruck, Tiefdruck, Flexodruck, Gravurdruck, Transferdruck, Digitaldruck, beispielsweise Ink-Jet-Druck, oder andere dem Fachmann bekannte Druckverfahren, oder durch Spray Coating aufgebracht werden können. Diese Verfahren sind einfach und preiswert.

Durch die Funktionsweise bedingt werden für die OLEDs und PLEDs Elektrodenmaterialien mit einer angepassten Austrittsarbeit gefordert. Diese bestehen für die Kathode beispielsweise aus Calcium, Barium oder Magnesium, die unter Umgebungsbedingungen sehr reaktiv sind und rasch oxidieren. Dagegen wird im Fall der LEC bezüglich Reaktivität und Oxidation als Kathode beispielsweise eine stabile Silber- oder Aluminiumelektrode verwendet. Diese kann durch ein Druckverfahren, beispielweise durch Siebdruck, Tiefdruck, Flexodruck, Gravurdruck, Transferdruck, Digitaldruck, beispielsweise Ink-Jet-Druck, oder andere dem Fachmann bekannte Druckverfahren, oder durch Spray Coating aufgebracht werden, während im Fall der OLEDs und PLEDs typischerweise das Aufdampfen angewendet wird, was wiederum einen Vakuumprozess erfordert. Weiterhin werden durch die Funktionsweise der LECs niedrigere Anforderungen hinsichtlich der Austrittsarbeit gestellt, so dass ein Elektrodenmaterial mit größerer Austrittsarbeit verwendet werden kann.

Bedingt durch die chemische Stabilität der Schichten der LEC kann diese hergestellt werden, ohne dass Temperatur, Luftdruck, Luftfeuchte oder Luftzusammensetzung kontrolliert oder eingestellt werden müssten oder gar eine Schutzgasatmosphäre, beispielsweise ein solche aus reinem Stickstoff mit einem maximalen Wasser- und Sauerstoffgehalt von jeweils 0,1 ppm oder aus einem vergleichbar sauerstofffreien und trockenen Gas oder Gasgemisch nötig wäre.

Um die Langzeitstabilität der mindestens einen LEC zu gewährleisten, ist die mindestens eine LEC auf ihrer dem Substrat zugewandten Seite mit einer ersten Barriereschicht versehen. Um dies zu gewährleisten ist das Substrat zumindest auf einer Seite und zwar auf der, die der LEC zugewandt ist, vollflächig oder nur teilweise, mindestens aber in den Bereichen, in denen sich die mindestens eine LEC befindet, mit einer ersten Barriereschicht versehen. Jedoch ist es auch möglich, dass das Substrat auf der der LEC abgewandten Seite mit einer ersten Barriereschicht versehen ist. Im Sinne der vorliegenden Erfindung kann es ich bei einer Barriereschicht um eine einzelne Schicht oder um mehrere Schichten handeln, die hinsichtlich ihrer Barriereeigenschaften wie eine einzelne Schicht wirken.

Diese erste Barriereschicht weist eine Wasserdampfdurchlässigkeit von 10⁻⁵ bis 10⁻¹ g/m⁻²•Tag, bevorzugt von 10⁻⁴ bis 10⁻² g/m⁻²• Tag, besonders bevorzugt von 10⁻⁴ bis 10⁻³ g/m⁻² •Tag und eine Sauerstoffdurchlässigkeit von 10⁻⁵ bis 10⁻¹ cm³/m-².•Tag, bevorzugt 10⁻⁴ bis 10⁻² cm³/m⁻²•Tag, besonders bevorzugt von 10⁻⁴ bis 10⁻³ cm³/m⁻²•Tag auf. Diese Barriereschicht ist also deutlich weniger aufwändig als die, die für OLEDs und PLEDs nötig sind.

Die erste Barriereschicht umfasst vorzugsweise eine Abfolge von Lagen je einer polymeren und einer anorganischen Schicht. Eine polymere Schicht besteht typischerweise aus einem photovernetzbaren Monomer bzw. Polymer (z.B. Acrylat). Die Dicke einer einzelnen polymeren Schicht beträgt dabei etwa 500 nm. Eine anorganische Schicht besteht typischerweise aus Metalloxiden, beispielsweise aus SiOₓ oder A1₂O₃. Die Dicke einer einzelnen anorganischen Schicht beträgt dabei etwa 50 nm. Die erste Barriereschicht umfasst vorzugsweise ein bis 10 Lagen, demzufolge kann die Dicke der Barriereschicht etwa 500 nm bis etwa 6000 nm betragen.

Die einzelnen Barriereschichten können durch Physical Vapor Deposition (PVD) und Chemical Vapor Deposition (CVD) in einem Rolle-zu-Rolle Verfahren aufgebracht werden.

Brauchbare Barriereschichten sind in beispielsweise in WO00/36665A1 und US6268695B1 offenbart.

Weiters ist das Substrat mindestens auf der Seite, die der mindestens einen LEC zugewandt ist, vollflächig oder nur teilweise, insbesondere in den Bereichen, in denen sich die mindestens eine LEC befindet, mit einer Elektrodenschicht versehen. Diese Elektrodenschicht, die für die LEC die Anodenschicht (kurz Anode) ist, ist typischerweise etwa 100 nm dick und besteht enthält ITO (Indium Tin Oxide), ATO (Antimon Tin Oxide), CNTs (CNT = Carbon Nanotube), beispielsweise SWCNTs (SWCNT = Single Wall Carbon Nanotube), Graphen oder ein intrinsisch leitfähigen Polymersystem wie beispielsweise PEDOT:PSS (Poly(3,4-ethylendioxythiophen) Poly(styrolsulfonat)), die beispielsweise von der H.C. Starck GmbH unter der Marke CLEVIOS und von der Agfa-Gevaert Group unter der Marke ORGACON vertrieben werden, oder Polyanillin, Polypyrrol oder Polythiophen. Auch die Anodenschicht kann mittels Druckverfahren, beispielweise durch Siebdruck, Tiefdruck, Flexodruck, Gravurdruck, Transferdruck, Digitaldruck, beispielsweise Ink-Jet-Druck, oder andere dem Fachmann bekannte Druckverfahren, oder durch Spray Coating aufgebracht werden. ITO und ATO können darüber hinaus mit PVD, CVD, Sputtern, Dipp Coating oder durch ein Sol-Gel-Verfahren aufgebracht werden. Die intrinsisch leitfähigen Polymere können auch durch Vakuumvernetzung aufgebracht werden.

Die Anodenschicht, soweit sie entsprechend ausgedehnt ist, kann auch anderen elektrotechnischen Bauelementen, die auf der gleichen Seite des Substrats befinden wie die LEC, als Elektrode dienen.

Soll nicht nur auf der Seite des Substrats, auf der sich die mindestens eine LEC befindet, sondern auch auf der anderen Seite mindestens ein weiteres elektrotechnisches Bauelement aufgebracht werden, können beide Seiten des Substrats mit einer Elektrodenschicht versehen werden. Es ist dann sicherzustellen, dass diese Elektrodenschichten ausreichend gegeneinander isoliert sind.

Im Übrigen werden Substrate aus Polyethylennaphthalat (PEN), die im Wesentlichen vollflächig auf einer Seite bereits mit einer wie oben beschriebenen ersten Barriereschicht und einer Anode aus ITO versehen sind von der 3M Deutschland GmbH zum Kauf angeboten.

Die Anode ist in den meisten Fällen transparent, so dass das elektrolumineszente Licht durch diese dringen kann. Alternartiv kann die Kathode transparent ausgeprägt sein. In diesem Fall kann die Anode optisch transparent oder teiltransparent sein.

In der planaren Anordnung können sowohl die Anode als auch die Kathode optisch nicht transparent sein, beispielsweise aus dünnen Silber oder Gold bestehen.

Unter "transparent" oder "Transparenz" wird im Sinne der vorliegenden Erfindung verstanden, dass eine betreffende Schicht bzw. eine betreffende Schichtfolge eine Transmission im Hauptanteil des sichtbaren oder IR-Wellenlängenbereichs des von der LEC abgestrahlten Lichts von mehr als 60 %, bevorzugt mehr als 70 %, besonders bevorzugt mehr als 80 %, ganz besonders mehr als 90 %, aufweist. Dies gilt auch dann, wenn die Schichtenfolge weitere, bisher hier nicht genannte Schichten umfasst.

Die Getterschicht, soweit vorhanden, liegt vorzugsweise auf der dem Substrat abgewandten Seite der Kathode, beispielsweise zwischen der Kathode und der einer weiter unten beschriebenen Trägerschicht mit der zweiten Barriereschicht oder dem ebenfalls weiter unten beschriebenen Metallfilm. Getter- und Trägerschicht bzw. Metallfilm können durch einen PSA-Film (PSA = pressure sensitive adhesive) oder einem flüssigen Kleber laminiert werden. Dabei kann die Getterschicht auf der Seite zur Trägerschicht als auch zur Kathode aufgebracht werden. Diese kann durch ein Druckverfahren, beispielweise durch Siebdruck, Tiefdruck, Flexodruck, Gravurdruck, Transferdruck, Digitaldruck, beispielsweise Ink-Jet-Druck, oder andere dem Fachmann bekannte Druckverfahren, oder durch Spray Coating aufgebracht werden.

Im Falle der mindestens einen LEC wird auf die Anodenschicht die LEP aufgebracht. Auch diese kann mittels Druckverfahren, beispielweise durch Siebdruck, Tiefdruck, Flexodruck, Gravurdruck, Transferdruck, Digitaldruck, beispielsweise Ink-Jet-Druck, oder andere dem Fachmann bekannte Druckverfahren, oder durch Spray Coating aufgebracht werden.

Auf die LEP wird dann eine weitere Elektrodenschicht, die für die mindestens eine LEC die Kathodenschicht (kurz Kathode) ist, aufgebracht. Die Kathodenschicht enthält Silber, Aluminium, Kupfer und/oder Gold und kann durch das Drucken von entsprechenden Pasten, beispielweise durch Siebdruck, Tiefdruck, Flexodruck, Gravurdruck, Transferdruck, Digitaldruck, beispielsweise Ink-Jet-Druck, oder andere dem Fachmann bekannte Druckverfahren, oder durch Spray Coating aufgebracht werden. Darüber hinaus sind auch die Materialen, die für die Anodenschicht geeignet sind, für die Kathode geeignet.

Die Kathodenschicht, soweit sie entsprechend ausgedehnt ist, kann auch anderen elektrotechnischen Bauelementen, die auf der gleichen Seite des Substrats befinden wie die LEC, als Elektrode dienen.

Als Materialien für die zur Stromversorgung der Elektroden notwendigen Leiterbahnen eignen sich die unter dem Abschnitten Anode und Kathode aufgeführten Substanzen. Diese können durch die ebenfalls in diesen Abschnitten aufgeführten Auftragungsverfahren aufgebracht werden.

Um die Langzeitstabilität der mindestens einen LEC zu gewährleisten, ist die mindestens eine LEC auf ihrer dem Substrat abgewandten Seite mit einer zweiten Barriereschicht versehen. Diese zweite Barriereschicht kann das Substrat vollflächig oder nur teilweise, mindestens aber in den Bereichen, in denen sich die mindestens eine LEC befindet, abdecken.

Die zweite Barriereschicht kann entsprechend der ersten Barriereschicht aufgebaut sein. Dann ist diese Barriereschicht auf einer Trägerschicht aufgebracht, die hinsichtlich Material und Eigenschaften dem Substrat entsprechen kann. Die zweite Barriereschicht kann in der gleichen Art und Weise auf die Trägerschicht aufgebracht werden wie die erste Barriereschicht auf das Substrat.

Die Trägerschicht mit der zweiten Barriereschicht ist derart aufgebracht, dass die Barriereschicht auf der der LEC zugewandten Seite der Trägerschicht liegt.

Alternativ kann die Trägerschicht mit der zweiten Barriereschicht derart aufgebracht sein, dass die Barriereschicht auf der der LEC abgewandten Seite der Trägerschicht liegt.

Alternativ zu der mit einer zweiten Barriereschicht versehenen Trägerschicht kann auch ein Metallfilm eingesetzt werden. Dieser weist hinsichtlich Wasserdampfdurchlässigkeit und Sauerstoffdurchlässigkeit die gleichen oder bessere Eigenschaften auf wie bzw. als die Barriereschicht. Eine Trägerschicht wird dann nicht mehr gebraucht.

Dieser Metallfilm besteht im Wesentlichen aus Aluminium, Gold, Silber, Kupfer, Chrom und hat eine Dicke von 10 bis 200 µm, bevorzugt von 50 bis 100 µm, besonders bevorzugt von 60 bis 80 µm. Alternativ kann der Metallfilm entsprechend der Barriereschicht auf der Trägerschicht aufgebracht sein, beispielsweise durch Lamination, Verklebung oder einem anderen dem Fachmann bekannten Verfahren. In einer weiteren alternativen Ausführungsform ist der Metallfilm durch PVD-Verfahren wie beispielsweise Sputtern auf die Trägerschicht aufgebracht worden.

Die Trägerschicht mit der zweiten Barriereschicht bzw. der Metallfilm sind vorzugsweise mittels einer adhäsiven Schicht (Klebstoffschicht), beispielsweise einer PSA-Schicht (PSA = pressure sensitve adhesive) auf die LEC und gegebenenfalls die anderen Bereiche zusammengefügt, insbesondere laminiert. Ist eine Getterschicht vorhanden, kann die adhäsive Schicht zwischen der zweiten Barriereschicht, auf der eine Getterschicht aufgebracht ist, und der LEC eingebracht werden. Danach kann die adhäsive Schicht gegebenenfalls mit geeigneter UV-Strahlung vernetzt werden.

Eine weitere Möglichkeit zur Ausbildung der adhäsiven Schicht besteht darin, anstelle eines PSA-Films einen flüssigen Kleber zu verwenden. Dieser wird beispielsweise mit einem Dispensionssystems oder mittels eines Druckverfahrens, beispielweise durch Siebdruck, Tiefdruck, Flexodruck, Gravurdruck, Transferdruck, Digitaldruck, beispielsweise Ink-Jet-Druck, oder andere dem Fachmann bekannte Druckverfahren, oder durch Spray Coating aufgebracht. Danach wird die Trägerschicht mit der zweiten Barriereschicht entsprechend über der LEC und gegebenenfalls den anderen Bereichen positioniert, laminiert und anschließend mit geeigneter UV Strahlung vernetzt.

Wird ein Metallfilm als Barriereschicht verwendet, bildet die adhäsive Schicht auch eine Isolationsschicht zur Kathode.

Außerdem kann der Schichtaufbau folgende weitere Schichten und/oder Komponenten aufweisen: gegebenenfalls eine oder mehrere Isolationsschichten, gegebenenfalls eine oder mehrere Schutzschichten, gegebenenfalls eine oder mehrere Dekorschichten, gegebenenfalls ein oder mehrere Farbfilter, gegebenenfalls eine oder mehrere Blenden. Beim Einsatz von Farbfiltern sind diese derart aufzubringen, dass das Licht der LEC durch sie hindurchstrahlt.

Damit das durch die LEP-Schicht erzeugte Licht der LEC abgestrahlt werden kann, muss die Schichtenfolge, die in Abstrahlungsrichtung, d.h. in Richtung des Substrats, auf der die mindestens eine LEC aufgebracht ist, transparent sein. Unter "transparent" oder "Transparenz" wird im Sinne der vorliegenden Erfindung verstanden, dass die betreffende Schicht bzw. die betreffende Schichtfolge eine Transmission im Hauptanteil des sichtbaren oder IR-Wellenlängenbereichs des von der LEC abgestrahlten Lichts von mehr als 60 %, bevorzugt mehr als 70 %, besonders bevorzugt mehr als 80 %, ganz besonders mehr als 90 %, aufweist. Dies gilt auch dann, wenn die Schichtenfolge weitere, bisher hier nicht genannte Schichten umfasst.

Außer der mindestens einen LEC ist auf dem Substrat mindestens ein weiteres elektrotechnisches Bauelement aufgebracht.

Elektrotechnische Bauelemente sind beispielsweise Antennen, Schalter, Sensoren, Batterien, Akkumulatoren (nachfolgend werden Batterie und Akkumulator zusammenfassend mit Batterie bezeichnet), Photovoltaikzellen, Aktuatoren, d.h. Systeme, die mit Hilfe elektrischer Energie eine Bewegung ausführen oder eine mechanische Kraft ausüben, Energiekonverter, d.h. Systeme, die eine Energieform in eine andere überführen. Weitere elektrotechnische Bauelemente sind dem Fachmann hinlänglich bekannt. Alle oben genannten elektrotechnischen Bauelemente sind durch drucktechnische Verfahren erhältlich. Einschlägige Druckschriften dazu sind für Antennen: US2009/066600A1; Schalter, Sensoren: US2009/0108985A1, US2007/0031161A1; Batterien: US2008/063931A1; Photovoltaikzellen: US2007/163638 A1; Aktuatoren, Energiekonverter: WO2009074192A1.

Dabei können die mindestens eine LEC und das mindestens eine weitere elektrotechnischen Bauelement bezüglich der Flächennormalen des Substrats sowohl übereinander als auch nebeneinander angeordnet sein. Die Flächennormale ist ein Vektor, der senkrecht auf einer Ebene steht, wobei diese Ebene theoretisch beliebig klein sein kann. Aus praktischen Erwägungen wird für die vorliegende Erfindung die kleinste Einheit dieser Ebene durch ein Quadrat mit der Kantenlänge 1 mm beschrieben.

Soweit möglich und nötig kann das mindestens eine weitere elektrotechnische Bauelement zweckmäßigerweise die Schichten nutzen, die für den Aufbau und die elektrische Versorgung der LEC vorhanden sind. Dies gilt insbesondere für die Anodenschicht, die Kathodenschicht, die erste Barrierenschicht, die zweite Barrierenschicht mit Trägerschicht bzw. den Metallfilm und die adhäsive Schicht, sowie die elektrischen Leiterbahnen und die Dekorschicht, soweit letztere vorhanden ist.

Die elektrischen Leiterbahnen können die mindestens eine LEC und das mindestens eine weitere elektrotechnische Bauelement auch untereinander elektrisch verbinden. So kann die mindestens eine LEC beispielsweise mit mindestens einem weiteren elektrotechnischen Bauelement ausgewählt aus der Gruppe bestehend aus Antenne, Schalter, Sensor, Batterie, Photovoltaikzelle, Aktuator, Energiekonverter oder Kombinationen von zwei oder mehreren gleichen oder verschiedenen dieser Bauelemente elektrisch verbunden sein, wobei die weiteren elektrischen Bauelemente auch untereinander elektrisch verbunden sein können.

Ist unter den elektrischen Bauelementen, mit denen die LEC verbunden ist und die gegebenenfalls auch untereinander elektrisch verbunden sind, keine Batterie, so ist eine übergeordnete Stromversorgung, d.h. eine Stromversorgung, die sich nicht auf dem Schichtaufbau befindet, nötig. Eine solche Stromversorgung kann beispielsweise sein: die Batterie des Gerätes, das den Schichtaufbau umfasst; die Batterie des Erzeugnisses, beispielsweise ein Automobil, in das das Gerät eingebaut ist; die öffentliche Stromversorgung, wenn der Schichtaufbau beispielsweise in ein Haushaltsgerät eingebaut ist.

Vorzugsweise umfasst der Schichtaufbau aber mindestens eine Batterie, die die Stromversorgung der LEC und gegebenenfalls weiterer elektrischer Bauelemente des Schichtaufbaus sicherstellt. Weiters vorzugsweise umfasst der Schichtaufbau neben der LEC und der Batterie mindestens noch ein weiteres elektrotechnisches Bauelement ausgewählt aus der Gruppe bestehend aus Antenne, Schalter, Sensor, Photovoltaikzelle, Aktuator, Energiekonverter oder Kombinationen von zwei oder mehreren gleichen oder verschiedenen dieser Bauelemente.

Das mindestens eine weitere elektrotechnische Bauelement kann auch an von einer oder von beiden Seiten mit einer Barriereschicht versehen sein, wobei es sich um die gleiche(n) und/oder dieselbe(n) Schicht(en) handeln kann, die auch die Barriereschicht(en) für die LEC bilden. Auch kann gegebenenfalls die Barriereschicht bei dem mindestens einen elektrotechnischen Bauelement durch einen Metallfilm entsprechend dem bei der LEC eingesetzten gebildet werden.

Wie vorstehend ausgeführt, kann der gesamte Schichtaufbau das Substrat, die mindestens eine LEC, das mindestens eine weitere elektrotechnische Bauelement, wobei die mindestens eine LEC und das mindestens eine weitere elektrotechnische Bauelement bezüglich der Flächennormalen des Substrats sowohl übereinander als auch nebeneinander angeordnet sein können, die erste Barriereschicht, die Anodenschicht, die Kathodenschicht, eine zweite Barriereschicht mit Trägerschicht oder ein Metallfilm, eine adhäsive Schicht und gegebenenfalls weitere Schichten wie beispielsweise eine oder mehrere Isolationsschichten, gegebenenfalls eine oder mehrere Schutzschichten, gegebenenfalls eine oder mehrere Dekorschichten, gegebenenfalls ein oder mehrere Farbfilter, gegebenenfalls eine oder mehrere Blenden umfassen. Die Dicke dieses Schichtaufbaus beträgt von 200 µm bis 3000 µm, bevorzugt von 500 µm bis 2000 µm, besonders bevorzugt von 800 µm bis 1500 µm

Um für den Benutzer ansprechend zu wirken und die Bedienung des Gerätes zu erleichtern, kann der Schichtaufbau dreidimensional verformte Bereiche aufweisen. Dreidimensional verformt im Sinne der Erfindung bedeutet, dass es, bezogen auf das Substrat des Schichtaufbaus, mindestens eine Flächennormale auf diesem Substrat gibt, sei es auf der Vorderseite oder auf der Rückseite des Substrats, die nicht parallel zu mindestens einer anderen Flächennormalen auf der gleichen Seite des Substrats ist. Nicht berücksichtigt werden dabei die normalen, produktionsbedingten Unebenheiten der Oberfläche des Substrats, die in einer Größenordung von höchstens + / - 20 µm vom Sollwert des Substrats liegen.

Dreidimensional verformt bedeutet also, dass während mindestens eines beliebigen Schrittes des Verfahrens zur Herstellung des Schichtaufbaus mindestens im Hinblick auf das Substrat eine bleibende Verformung bezüglich mindestens einer Raumachse stattgefunden hat. Verformung bedeutet also nicht nur das Herstellen von Ein- oder Ausstülpungen in eine oder aus einer im Wesentlichen ebenen Fläche, sondern beispielsweise auch das Biegen, Knicken oder Wellen dieser Fläche.

Dabei kann der Schichtaufbau in Bereichen, die mit einer Batterie, einer Antenne, einem Schalter, einem Sensor, einer Photovoltaikzelle, einem Aktuator oder einem Energiekonverter versehen sind, dreidimensional verformt sein. Der Krümmungsradius des Schichtaufbaus in den verformten Bereichen kann dabei kleiner als 10 mm, bevorzugt kleiner als 5 mm, besonders bevorzugt kleiner als 2 mm, ganz besonders bevorzugt kleiner als 1 mm sein.

Vorzugsweise ist der Schichtaufbau in Bereichen, die mit einer Batterie, einer Antenne, einem Schalter, einem Sensor, einer Photovoltaikzelle, einem Aktuator oder einem Energiekonverter versehen sind, jedoch mit einer Aus- oder Einstülpung mit dem oben genannten Krümmungsradius versehen.

Im Sinne der Erfindung wird der Krümmungsradius an der Mittelebene des Substrats bestimmt.

Bei der Verformung ist darauf zu achten, dass die Bereiche des Schichtaufbaus, die mit mindestens einer LEC versehen sind, nicht oder nur sehr gering verformt werden, da die Barriereschichten einer oben beschriebenen Verformung nicht standhalten und somit ihre Barriereeigenschaften vermindert werden. Dies führt zu einer verringerten Lebensdauer der LEC. Jedoch ist eine Verformung des Schichtaufbaus als Ganzes - und damit auch der Barriereschichten - mit einem Krümmungsradius von 1 m und mehr, bevorzugt von 2 bis 10 m, besonders bevorzugt von 3 bis 5 m möglich, ohne dass es zu Schäden der Barriereschicht kommt, die zu einer spürbaren Verringerung der Lebensdauer der LEC führen.

Daher kann beispielsweise eine in der Draufsicht runde, ellipsoide oder anders geometrisch gestaltetet Kombination von LEC und einem elektrotechnischen Bauelement, beispielsweise ein Schalter oder Sensor, derart ausgestaltet sein, dass in der Mitte ein in Richtung des Bedieners ausgestülpter Schalter liegt, der von einer flachen ringförmigen, ellipsoidumfangsförmigen oder sonst entsprechend dem Umfang der Ausstülpung ausgestalteten LEC umgeben ist.

Alternativ kann die LEC flach in der Mitte einer solchen Kombination liegen, während die entsprechenden elektrotechnischen Bauelemente als Ausstülpungen dem Umfang der LEC folgen.

Der erfindungsgemäße Schichtaufbau ist erhältlich durch folgendes Verfahren:
(1) Bereitstellen eines Substrats, das ganz- oder teilflächig mit mindestens einer Barriereschicht und mit mindestens einer Anodenschicht versehen ist;
(2) gegebenenfalls Strukturieren der mindestens einen Anodenschicht und gegebenenfalls von elektrischen Leiterbahnen;
(3) Aufbringen der mindestens einen LEP-Schicht auf das Substrat an einer Stelle, die sowohl mit mindestens einer Barriereschicht als auch mit mindestens einer Anodenschicht versehen ist und an der die mindestens eine LEC ausgebildet werden soll;
(4) Aufbringen mindestens einer Kathodenschicht zumindest an der Stelle, an der sich die mindestens eine LEP-Schicht befindet, und gegebenenfalls von elektrische Leiterbahnen;
(5) Aufbringen einer adhäsiven Schicht (Klebstoffschicht) zumindest an der Stelle, an der sich die mindestens eine LEC befindet;
(6) Aufbringen mindestens einer Metallfolie oder einer zweiten Barriereschicht und einer Trägerschicht zumindest an der Stelle, an der sich die mindestens eine LEC befindet, derart, dass die mindestens eine LEC zwischen zwei Barriereschichten angeordnet ist;
(7) Aufbringen des mindestens einen weiteren elektrotechnischen Bauelements;
(8) gegebenenfalls Aufbringen eines weiteren elektrotechnischen Bauelements oder mehrerer weiterer elektrotechnischer Bauelemente;
wobei zusätzlich folgende Schichten aufgebracht werden: eine oder mehrere elektrische Leiterbahnen, gegebenenfalls eine oder mehrere Isolationsschichten, gegebenenfalls eine oder mehrere Schutzschichten, gegebenenfalls eine oder mehrere Dekorschichten, gegebenenfalls ein oder mehrere Farbfilter, gegebenenfalls eine oder mehrere Blenden,
und der Schichtaufbau danach in mindestens einem Bereich und/oder als Ganzes dreidimensional verformt wird.

Dabei können
(a) die Schritte in der angegebenen Reihenfolge ausgeführt werden; oder
(b) Schritt (7) und gegebenenfalls Schritt (8) an beliebiger Stelle nach Schritt (2) ausgeführt werden.

Unter "Strukturieren der mindestens einen elektrisch leitfähigen Schicht" wird im Rahmen der vorliegenden Erfindung verstanden, dass die betreffende Schicht bzw. die betreffende Schichtfolge derart von dem Substrat entfernt, beispielsweise durch chemische Verfahren, Laserablation, Stanzen oder durch mindestens eine dielektrische Schicht abgedeckt wird, beispielsweise durch Aufdrucken einer Isolationsschicht, wiederum beispielsweise durch Siebdruck, dass nur die Bereiche als Elektrode (Anode) für die mindestens eine LEC übrig bzw. frei bleiben, die für den Betrieb dieser LEC nötig sind und/oder den Betrieb weiterer elektrotechnischer Bauelemente des Bediensystems nicht stören. Gegebenenfalls können die elektrischen Leiterbahnen in entsprechender Weise strukturiert werden oder aus der mindestens einen elektrisch leitfähigen Schicht herausgearbeitet werden.

Um eine dreidimensional verformten Schichtaufbau zu erhalten, muss der Schichtaufbau verformt werden. Die Verformung geschieht beispielsweise durch isostatische Hochdruckverformung, wie sie in EP 0 371 425 A2 und WO2009/043539 A2 offenbart ist. Auch ist eine Verformung durch Thermoforming möglich, wie sie in US5932167A, US6210623B1 und US6257866B1 offenbart ist.

Sowohl der flache, das heißt der nicht verformte, als auch der dreidimensional verformte Schichtaufbau können mit einem Kunststoff hinterspritzt werden, wie auch bereits in EP0371425A2 und WO2009/043539A2 offenbart.

Der erfindungsgemäße Schichtaufbau kann zur Ausbildung von kleinen und großen Anzeige- und Steuerelementen und zur Ausbildung von Gehäuseelementen für mobile oder stationäre Elektronikgeräte oder kleiner oder großer Haushaltsgeräte oder zur Ausbildung von Tastatursystemen ohne bewegliche Bauteile verwendet werden.

Im Folgenden wird der erfindungsgemäße Schichtaufbau anhand beispielhafter Ausführungsformen für die Schichtabfolge näher dargestellt, wobei die erfindungswesentlichen Merkmale hervor gehoben werden sollen, ohne die Erfindung darauf einzuschränken.

Für alle gewählten Beispiele gilt, dass die LEC und das elektrotechnische Bauelement bezüglich der Flächennormalen des Substrats übereinander angeordnet sind und das von der LEP ausgestrahlte Licht den Schichtaufbau in der Richtung verlässt, in der sich von der LEP aus gesehen die Anode befindet. Wenn keine Metallschicht vorhanden ist und die Getterschicht fehlt oder die Getterschicht transparent ist, so kann das Licht den Schichtaufbau sowohl in Richtung der Anode als auch in Richtung der Kathode verlassen, soweit alle anderen Schichten auch transparent sind, was erfindungsgemäß in Richtung Anode obligatorisch und in Richtung Kathode die Regel ist.

### Beispiele

### Beispiel 1:

Blende, Schalter, Trägerschicht, Barriereschicht, Getterschicht, adhäsive Schicht, Kathode, LEP, Anode, Barriereschicht, Substrat, Farbfilter, Dekorfilm.

### Beispiel 2:

Blende, Schalter, Isolationsschicht, Metallfilm, Getterschicht, adhäsive Schicht, Kathode, LEP, Anode, Barriereschicht, Substrat, Farbfilter, Dekorfilm.

### Beispiel 3:

Trägerschicht, Barriereschicht, Getterschicht, adhäsive Schicht, Kathode, LEP, Anode, Barriereschicht, Substrat, Farbfilter, Schalter, Dekorfilm.

### Beispiel 4:

Metallfilm, Getterschicht, adhäsive Schicht, Kathode, LEP, Anode, Barriereschicht, Substrat, Farbfilter, Schalter, Dekorfilm.

### Beispiel 5:

Trägerschicht, Barriereschicht, adhäsive Schicht, Schalter, Isolationsschicht, Getterschicht, Isolationsschicht, Kathode, LEP, Anode, Barriereschicht, Substrat, Farbfilter, Dekorfilm.

### Beispiel 6:

Trägerschicht, Barriereschicht, Getterschicht, adhäsive Schicht, Kathode, LEP, Anode, Barriereschicht, Substrat, Farbfilter, adhäsive Schicht, Schalter, Trägerschicht, Dekorfilm.

### Beispiel 7:

Metallfilm, Getterschicht, adhäsive Schicht, Kathode, LEP, Anode, Barriereschicht, Substrat, Farbfilter, adhäsive Schicht, Schalter, Trägerschicht, Dekorfilm.

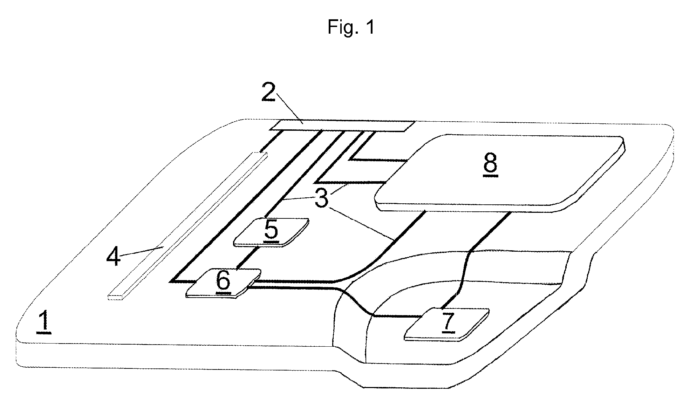

Weiters wird nachfolgend die Erfindung anhand einer Zeichnung (Fig. 1) näher erläutert; auch dabei sollen die erfindungswesentlichen Merkmale hervor gehoben werden, ohne die Erfindung darauf einzuschränken.

Fig. 1 zeigt einen Schichtaufbau umfassend Substrat 1, elektrischen Steckkontakt 2, elektrische Verbindungen 3, Antenne 4, Sensor 5, Schalter 6, LEC 7 und Batterie 8. Wie erkennbar, ist der Schichtaufbau derart dreidimensional verformt, dass die LEC 7 bezogen auf alle anderen Komponenten 2-6 auf einem tieferen Niveau angeordnet ist. An den Übergängen zwischen dem Hauptniveau des Schichtaufbaus und dem tieferen Niveau der LEC 7 sind vorliegend ausschließlich elektrische Verbindungen 3 angeordnet. Es ist jedoch auch prinzipiell möglich, andere der Komponenten auf dem dreidimensional verformten Übergangsbereich zwischen dem tieferen Niveau und dem übrigen Niveau des Schichtaufbaus anzuordnen.

## Patentansprüche

1. Schichtaufbau umfassend
A) ein Substrat (1),
B) mindestens eine LEC (7) (light emitting electrochemical cell) und
C) mindestens ein weiteres elektrotechnisches Bauelement ausgewählt aus der Gruppe bestehend aus Antenne (4), Schalter, Sensor (5), Batterie (8), Photovoltaikzelle, Aktuator, Energiekonverter oder Kombinationen von zwei oder mehreren gleichen oder verschiedenen dieser Bauelemente,
**dadurch gekennzeichnet, dass** sich die mindestens eine LEC (7) und das mindestens eine weitere elektrotechnische Bauelement (4, 5, 8) auf demselben Substrat (1) befinden und der Schichtaufbau mindestens einen dreidimensional verformten Bereich (9) aufweist und/oder als Ganzes dreidimensional verformt ist.

2. Schichtaufbau nach Anspruch 1, **dadurch gekennzeichnet, dass** das mindestens eine weitere elektrotechnische Bauelement eine Batterie (8) ist.

3. Schichtaufbau nach Anspruch 1 oder 2, **dadurch gekennzeichnet, dass** der Schichtaufbau mindestens ein weiteres elektrotechnisches Bauelement ausgewählt aus der Gruppe bestehend aus Antenne (4), Schalter, Sensor (5), Photovoltaikzelle, Aktuator, Energiekonverter oder Kombinationen von zwei oder mehreren gleichen oder verschiedenen dieser Bauelemente umfasst.

4. Schichtaufbau nach Anspruch 1, **dadurch gekennzeichnet, dass** das Substrat (1) im Wesentlichen oder ganz aus einem Polymer besteht, ausgewählt aus der Gruppe bestehend aus Polycarbonaten (PC), Polyestern, bevorzugt Polyethylenterephthalaten (PET), Polyethylennaphthalat (PEN), Polymethylmethacrylaten (PMMA), Polyamiden, Polyimiden, Polyarylaten, organischen thermoplastischen Celluloseestern und Polyfluorkohlenwasserstoffen oder Mischungen aus diesen Polymeren, bevorzugt ausgewählt aus Polycarbonaten, Polyethylenterephthalaten, Polyethylennaphthalat und Polyimiden, besonders bevorzugt ausgewählt aus Polycarbonaten, Polyethylenterephthalaten und Polyethylennaphthalat.

5. Schichtaufbau nach Anspruch 1, **dadurch gekennzeichnet, dass** die mindestens eine LEC (7) auf ihrer dem Substrat (1) zugewandten Seite mit einer Barriereschicht und einer Anodenschicht versehen ist.

6. Schichtaufbau nach Anspruch 1, **dadurch gekennzeichnet, dass** die mindestens eine LEC (7) auf ihrer dem Substrat (1) abgewandten Seite mit einer Kathodenschicht sowie einer Metallfolie oder einer zweiten Barriereschicht und einer Trägerschicht versehen ist, wobei die Metallfolie und die Barriereschicht mit Trägerschicht vorzugsweise mit einer adhäsiven Schicht (Klebstoffschicht) aufgebracht sind.

7. Schichtaufbau nach Anspruch 1, **dadurch gekennzeichnet, dass** der Schichtaufbau folgende weitere Schichten und/oder Komponenten aufweist:
eine oder mehrere elektrische Leiterbahnen, gegebenenfalls eine oder mehrere Isolationsschichten, gegebenenfalls eine oder mehrere Schutzschichten, gegebenenfalls eine oder mehrere Dekorschichten, gegebenenfalls ein oder mehrere Farbfilter, gegebenenfalls eine oder mehrere Blenden.

8. Schichtaufbau nach Anspruch 1, **dadurch gekennzeichnet, dass** der Schichtaufbau in mindestens einem Bereich, der mit einer Batterie (8), einer Antenne (4), einem Schalter, einem Sensor (5), einer Photovoltaikzelle, einem Aktuator oder einem Energiekonverter versehen ist, dreidimensional verformt ist.

9. Schichtaufbau nach Anspruch 8, **dadurch gekennzeichnet, dass** der Krümmungsradius des Schichtaufbaus in dem verformten Bereich kleiner als 10 mm, bevorzugt kleiner als 5 mm, besonders bevorzugt kleiner als 2 mm, ganz besonders bevorzugt kleiner als 1 mm ist.

10. Verfahren zur Herstellung eines Schichtaufbaus nach Anspruch 1, **gekennzeichnet durch** folgende Schritte:
(1) Bereitstellen eines Substrats (1), das ganz- oder teilflächig mit mindestens einer Barriereschicht und mit mindestens einer Anodenschicht versehen ist;
(2) gegebenenfalls Strukturieren der mindestens einen Anodenschicht und gegebenenfalls von elektrischen Leiterbahnen;
(3) Aufbringen der mindestens einen LEP-Schicht auf das Substrat (1) an einer Stelle, die sowohl mit mindestens einer Barriereschicht als auch mit mindestens einer Anodenschicht versehen ist;
(4) Aufbringen mindestens einer Kathodenschicht zumindest an der Stelle, an der sich die mindestens eine LEP-Schicht befindet, und gegebenenfalls von elektrischen Leiterbahnen;
(5) Aufbringen einer adhäsiven Schicht (Klebstoffschicht) zumindest an der Stelle, an der sich die mindestens eine LEC befindet;
(6) Aufbringen mindestens einer Metallfolie oder einer zweiten Barriereschicht und einer Trägerschicht zumindest an der Stelle, an der sich die mindestens eine LEC befindet, derart, dass die mindestens eine LEC zwischen zwei Barriereschichten angeordnet ist;
(7) Aufbringen des mindestens einen weiteren elektrotechnischen Bauelements (4, 5, 8);
(8) gegebenenfalls Aufbringen eines weiteren elektrotechnischen Bauelements oder mehrerer weiterer elektrotechnischer Bauelemente (4, 5, 8);
wobei zusätzlich folgende Schichten aufgebracht werden: eine oder mehrere elektrische Leiterbahnen, gegebenenfalls eine oder mehrere Isolationsschichten, gegebenenfalls eine oder mehrere Schutzschichten, gegebenenfalls eine oder mehrere Dekorschichten, gegebenenfalls ein oder mehrere Farbfilter,
und der Schichtaufbau danach in mindestens einem Bereich und/oder als Ganzes dreidimensional verformt wird.

11. Verfahren nach Anspruch 10, **dadurch gekennzeichnet, dass**
(a) die Schritte in der angegebenen Reihenfolge ausgeführt werden; oder
(b) Schritt (7) und gegebenenfalls Schritt (8) an beliebiger Stelle nach Schritt (2) ausgeführt werden.

12. Verfahren nach Anspruch 10, **dadurch gekennzeichnet, dass** die LEP-Schicht, die Kathodenschicht, die adhäsive Schicht, gegebenenfalls die zweite Barriereschicht, die elektrischen Leiterbahnen, die gegebenenfalls vorhandene Isolationschicht, die gegebenenfalls vorhandene Schutzschicht und die gegebenenfalls vorhandene Dekorschicht sowie gegebenenfalls die Anodenschicht vollständig durch ein Druckverfahren aufgebracht werden.

13. Verfahren nach Anspruch 10, **dadurch gekennzeichnet, dass** die Verformung durch isostatische Hochdruckverformung oder Thermoforming erreicht wird.

14. Verfahren nach Anspruch 10, **dadurch gekennzeichnet, dass** der dreidimensional verformte Schichtaufbau hinterspritzt wird.

15. Verwendung eines Schichtaufbaus nach Anspruch 1 oder hergestellt nach Anspruch 10 zur Ausbildung von kleinen und großen Anzeige- und Steuerelementen und zur Ausbildung von Gehäuseelementen für mobile oder stationäre Elektronikgeräte oder kleiner oder großer Haushaltsgeräte oder zur Ausbildung von Tastatursystemen ohne bewegliche Bauteile.
